(19)

Europäisches
Patentamt
European
Patent Office
Office européen
des brevets

(11) **EP 3 654 119 A1**

(12) **EUROPEAN PATENT APPLICATION**
published in accordance with Art. 153(4) EPC

(43) Date of publication:
**20.05.2020 Bulletin 2020/21**

(51) Int Cl.:
***G05B 17/02*** *(2006.01)*

(21) Application number: **18832753.0**

(22) Date of filing: **04.07.2018**

(86) International application number:
**PCT/JP2018/025338**

(87) International publication number:
**WO 2019/013067 (17.01.2019 Gazette 2019/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.07.2017 JP 2017136283**

(71) Applicant: **Kyushu University, National University
Corporation
Fukuoka-shi, Fukuoka 819-0395 (JP)**

(72) Inventor: **KIKUUWE, Ryo
Fukuoka-shi, Fukuoka 819-0395 (JP)**

(74) Representative: **HGF Limited
Saviour House
9 St. Saviourgate
York YO1 8NQ (GB)**

(54) **FORCE CONTROL DEVICE, FORCE CONTROL METHOD, AND FORCE CONTROL PROGRAM**

(57)     Provided is a force control device and the like
that can, even in the case of torque saturation, reduce
positional deviation between a virtual object and a control
target by using an algebraic loop to feedback a position
of the virtual object, and improve stability while improving
followability. The force control device includes: a position
detector that detects a position of the control target; a
force sensor 11 that detects a force by which the control
target is in contact with an object; a moving mechanism
41 that movably holds the control target; a driving unit 42
that includes a motor that uses a torque command value
as an input to operate the moving mechanism 41; and a
computing unit 40 that determines the torque command
value. The computing unit 40 stores a virtual object 12
having predetermined dynamic characteristics, and a po-
sition controller 13, and is configured to: calculate a position at a next time, the position being calculated by simulating a motion of the virtual object when a target force
exerted on the control target and a measured value of
the force sensor 11 are given to the virtual object; obtain
a torque calculated when the calculated position is given
to the position controller 13 as a target position at the
next time; and, when the obtained torque is outside the
predetermined range set previously, determine the position of the virtual object 12 at the next time based on a
boundary value of the predetermined range and the ob-
tained torque.

Fig. 2

**Description**

Technical Field

The present invention relates to a force control device that performs admittance control using a force sensor, and the like.

Background Art

When a robot manipulator is operating in contact with an external environment, an appropriate controller is needed to control a contact force between an end effector of the robot and the environment. This type of controller has been proposed in Non-Patent Literatures 1 and 2. In a situation where a force sensor is available and a robot joint has high friction, a control method called admittance control (Non-Patent Literature 3) is often used (Non-Patent Literatures 3 to 5). This type of controller assumes a virtual object having simple dynamic characteristics in a controller, and simulates a motion of the virtual object using information on a force measured by the force sensor. The position of a robot is controlled so as to track the motion of the virtual object. As long as the position control is sufficiently accurate, a response of the robot to an external force is close to that of the virtual object. This control method has been applied to force sense presentation (Non-Patent Literatures 4 and 5), remote control (Non-Patent Literature 6), rehabilitation (Non-Patent Literature 7), human-machine collaborative work (Non-Patent Literature 8), and some kind of manufacturing processes (Non-Patent Literature 9). In most applications, the magnitude of a robot actuator force is limited by hardware limitations or safety reasons.

One of the problems of an actuator force saturation in the admittance control is that the position of a robot tends to move away from that of a virtual object when an actuator force is saturated. The actuator force may be saturated and an abrupt change in the speed of the virtual object may occur. Setting inertia and viscosity of the virtual object high when there is a possibility that a large external force acts on the robot, contributes to the prevention of the saturation. However, it will result in sluggish responsiveness to a contact force, which is often inappropriate.

Control methods using an external force feedback loop and an internal position loop can be found in some literatures since the 1970's. Controllers for use in these methods can be classified into an explicit force controller (Non-Patent Literatures 11 to 13) and an impedance controller (Non-Patent Literatures 14 to 17). The former controls the force on an end effector, and the latter controls the apparent mechanical impedance of the end effector. These two types can be implemented in a similar framework (the difference is whether a target force command is provided or not). These controllers are referred to as various names such as "virtual internal model following control" (Non-Patent Literatures 9 and 18), "position control based impedance control" (Non-Patent Literatures 19 and 20), and "admittance control" (Non-Patent Literatures 4, 5, 7, and 8).

Stability is a major challenge for an admittance controller. The main causes of instability are time delay in the controller (Non-Patent Literatures 12 and 23) and band limitation of an internal position control system (Non-Patent Literatures 24 to 26). In order to suppress instability, it is known that virtual mass and virtual viscosity should be set high. However, it may degrade the reactivity of the controller, so that high virtual mass or virtual viscosity is not always desirable. The minimum feasible virtual mass is also one evaluation index for an admittance-controlled device (Non-Patent Literature 5). In order to improve the stability without increasing the virtual mass and the virtual viscosity, the transfer function from a virtual object position to an actual position needs to be close to 1. In order to achieve this, some of the prior art techniques use a position controller including a feedforward term (which can be regarded as a phase lead compensator) to compensate for the effect of dynamic characteristics of a robot (Non-Patent Literatures 22, 27, and 28).

With respect to the actuator saturation, the only analytical study on the problem of how to avoid it is the work of Gonzalez and Widmann (Non-Patent Literature 29). This study points out that saturation improves stability of a control target because saturation temporarily makes the system equivalent to an open-loop system. However, this technique does not take into account such a situation where positive and negative saturations occur alternately, which is usually undesirable.

A control technique that can be used to solve such a problem is the proxy-based sliding mode control (PSMC) proposed by Non-Patent Literature 10 and Non-Patent Literature 1. This technique comprises not only some kind of discrete-time approximation of a simple sliding mode controller but also an extension of a PID controller in which saturation may occur.

The PSMC is equivalent to the PID when a torque is unsaturated, so that the current position following characteristic with respect to a target position may be insufficient. In the case of PSMC, with respect to the torque saturation, $\tau$ becomes discontinuous at the time of transition from the saturated to the unsaturated, which causes an operator who touches a robot to feel uncomfortable. For such a problem, it is disclosed a technique relating to a force control device using the admittance control that is provided with a position controller that can improve position following capability even when a position command changes frequently and suddenly, and can suppress discontinuous movement even when the torque is saturated (Patent Literature 2).

Citation List

Non-Patent Literature

Non-Patent Literature 1 : D. E. Whitney, "Historical perspective and state of the art in robot force control," Int. J. Robotics Research, vol. 6, no. 1, pp. 3-14, 1987.

Non-Patent Literature 2 : G. Zeng and A. Hemami, "An overview of robot force control," Robotica, vol. 15, pp. 473-482, 1997.

Non-Patent Literature 3 : C. Ott, R. Mukherjee, and Y. Nakamura, "Unified impedance and admittance control," in Proc. IEEE Int. Conf. Robotics and Automation, 2010, pp. 554-561.

Non-Patent Literature 4 : M. Ueberle and M. Buss, "Control of kinesthetic haptic interfaces," in Proc. Workshop on Touch and Haptics, IEEE/RSJ Int. Conf. Intelligent Robots and Systems, 2004, pp. 1-14.

Non-Patent Literature 5 : R. Q. Van Der Linde and P. Lammertse, "HapticMaster - ageneric force controlled robot for human interaction," Industrial Robot, vol. 30, no. 6, pp. 515-524, 2003.

Non-Patent Literature 6 : A. Peer and M. Buss, "A new admittance-type haptic interface for bimanual manipulations," IEEE/ASME Trans. Mechatronics, vol. 13, no. 4, pp. 416-428, 2008.

Non-Patent Literature 7 : P. R. Culmer, A. E. Jackson, S. Makower, R. Richardson, J. A. Cozens, M. C. Levesley, and B. B. Bhakta, "A control strategy for upper limb robotic rehabilitation with a dual robot system," IEE E/ASME Trans. Mechatronics, vol. 15, no. 4, pp. 575-585, 2010.

Non-Patent Literature 8 : N. Takesue, H. Murayama, K. Fujiwara, K. Matsumoto, H. Konosu, and H. Fujimoto, "Kinesthetic assistance for improving task performance - the case of window installation assist -," Int. J. Automation Technology, vol. 3, no. 6, pp. 663-670, 2009.

Non-Patent Literature 9 : H. Arai, "Force-controlled metal spinning machine using linear motors," in Proc. IEEE Int. Conf. Robotics and Automation, 2006, pp. 4031-4036.

Non-Patent Literature 10 : R. Kikuuwe, S. Yasukouchi, H. Fujimoto, and M. Yamamoto, "Proxybased sliding mode control: A safer extension of PID position control," IEEE Trans. Robotics, vol. 26, no. 4, pp. 860-873, 2010.

Non-Patent Literature 11 : J. De Schutter, "A study of active compliant motion control methods for rigid manipulators based on a generic scheme," in Proc. IEEE Int. Conf. Robotics and Automation, vol. 4, 1987, pp. 1060-1065.

Non-Patent Literature 12 : H. Ishikawa, C. Sawada, K. Kawase, and M. Takata, "Stable compliance control and its implementation for a 6 DOF manipulator," in Proc. IEEE Int. Conf. Robotics and Automation, vol. 1, 1989, pp. 98-103.

Non-Patent Literature 13 : H. Seraji, "Adaptive admittance control: an approach to explicit force control in compliant motion," in Proc. IEEE Int. Conf. Robotics and Automation, 1994, pp. 2705-2712.

Non-Patent Literature 14 : D. E. Whitney, "Force feedback control of manipulator fine motions," Trans. ASME: J. Dynamic Systems, Measurement, and Control, vol. 99, no. 2, pp. 91-97, 1977.

Non-Patent Literature 15 : G. Hirzinger, "Direct digital robot control using a force-torque sensor," in Proc. IFAC Symp. Real Time Digital Control Applications, 1983, pp. 243-255.

Non-Patent Literature 16 : J. De Schutter and H. Van Brussel, "A methodology for specifying and controlling compliant robot motion," in Proc. 25th Conf. Decision and Control, 1986, pp. 1871-1876.

Non-Patent Literature 17 : J. A. Maples and J. J. Becker, "Experiments in force control of robotic manipulators," in Proc. IEEE Int. Conf. Robotics and Automation, 1986, pp. 695-702.

Non-Patent Literature 18 : K. Kosuge, K. Furuta, and T. Yokoyama, "Virtual internal model following control of robot arms," in Proc. 1987 IEEE Int. Conf. Robotics and Automation, 1987, pp. 1549-1554.

Non-Patent Literature 19 : D. A. Lawrence and R. M. Stoughton, "Position-based impedance control - achieving stability in practice," in Proc. AIAA Guidance, Navigation and Control Conference, 1987, pp. 221-226.

Non-Patent Literature 20 : D. Surdilovic and J. Kirchhof, "A new position based force/impedance control for industrial robots," in Proc. IEEE Int. Conf. Robotics and Automation, 1996, pp. 629-634.

Non-Patent Literature 21 : R. Volpe and P. K. Khosla, "A theoretical and experimental investigation of explicit force control strategies for manipulators," IEEE Trans. Automatic Control, vol. 38, no. 11, pp. 1634-1650, 1993.

Non-Patent Literature 22 : J. J. Gonzalez and G. R. Widmann, "A force commanded impedance control scheme for robots with hard nonlinearities," IEEE Trans. Control Systems Technology, vol. 3, no. 4, pp. 398-408, 1995.

Non-Patent Literature 23 : D. A. Lawrence, "Impedance control stability properties in common implementation," in Proc. IEEE Int. Conf. Robotics and Automation, 1988, pp. 1185-1190.

Non-Patent Literature 24 : S. D. Eppinger and W. P. Seering, "Understanding bandwidth limitations in robot force control," Proc. IEEE Int. Conf. Robotics and Automation, vol. 4, pp. 904-909, 1987.

Non-Patent Literature 25 : T. Valency and M. Zacksenhouse, "Accuracy/robustness dilemma in impedance control," Trans. ASME: J. Dynamic Systems, Measurement, and Control, vol. 125, no. 3, pp. 310-319, 2003.

Non-Patent Literature 26 : S. H. Kang, M. Jin, and P. H. Chang, "A solution to the accuracy/ robustness dilemma in impedance control," IEEE/ASME Trans. Mechatronics, vol. 14, no. 3, pp. 282-294, 2009.

Non-Patent Literature 27 : S. Tafazoli, S. E. Salcudean, K. Hashtrudi-Zaad, and P.D. Lawrence, "Impedance control of a teleoperated excavator," IEEE Trans. Control Systems Technology, vol. 10, no. 3, pp. 355-367, 2002.

Non-Patent Literature 28 : G. Ferretti, G. Magnani, and P. Rocco, "Impedance control for elastic joints industrial manipulators," IEEE Trans. Robotics and Automation, vol. 20, no. 3, pp. 488-498, 2004.

Non-Patent Literature 29 : J. J. Gonzalez and G. R. Widmann, "Investigation of nonlinearities in the force control of real robots," IEEE Trans. Systems, Man, and Cybernetics, vol. 22, no. 5, pp. 1183-1193, 1992.

Patent Literature

Patent Literature 1: Japanese Unexamined Patent Application Publication No. 2007-102748

Patent Literature 2: Japanese Patent No. 6032811

Summary of Invention

Technical Problem

The technique disclosed in Patent Literature 2 can suppress discontinuous movement even at the time of torque saturation while improving position following capability, but may inevitably cause discomfort when the follow-up processing is performed, because the position of a virtual object and the position of a robot will be separated away from each other.

The present invention provides a force control device and the like that can, even in the case of torque saturation, reduce positional deviation between a virtual object and a control target by feeding back a position of the virtual object, and improve stability while improving followability.

Solution to Problem

A force control device according to the present invention is provided with: a position detector that detects a position of a control target; a force sensor that detects a force by which the control target is in contact with an object; a moving mechanism that movably holds the control target; a driving unit that includes a motor that uses a torque command value as an input to operate the moving mechanism; and a computing unit that determines the torque command value, wherein the computing unit stores a virtual object having predetermined dynamic characteristics, and a position control rule, and is configured to: calculate a position at a next time, the position being calculated by simulating a motion of the virtual object when a target force exerted on the control target and a measured value of the force sensor are given to the virtual object; obtain a torque calculated when the calculated position is given to the position control rule as a target position at the next time; when the obtained torque is within a predetermined range set previously, determine the obtained torque as the torque command value to determine the calculated position as a position of the virtual object at the next time; and when the obtained torque is outside the predetermined range set previously, determine the position of the virtual object at the next time based on a boundary value of the predetermined range and the obtained torque.

As described above, the force control device according to the present invention is provided with: a position detector that detects a position of a control target; a force sensor that detects a force by which the control target is in contact with an object; a moving mechanism that movably holds the control target; a driving unit that includes a motor that uses a torque command value as an input to operate the moving mechanism; and a computing unit that determines the torque command value, and when the calculated torque is outside the predetermined range set previously, the position of the virtual object at the next time is determined based on a boundary value of the predetermined range and the calculated torque, so that positional deviation between the virtual object and the control target is reduced, resulting in that it is possible to improve stability while improving followability.

Brief Description of Drawings

FIG. 1 is a functional block diagram showing an example of a processing concept of a conventional force control device.

FIG.2 is a functional block diagram showing an example of a processing concept of a force control device according to a first embodiment.

FIG. 3 is a hardware configuration diagram of the force control device according to the first embodiment.

FIG. 4 is a functional block diagram of the force control device according to the first embodiment.

FIG. 5 is a flowchart illustrating an operation of the force control device according to the first embodiment.

FIG. 6 is a photograph of a robot used in the Example.

FIG. 7 is a diagram showing a result of an admittance control when a conventional method was used.

FIG. 8 is a diagram showing a result of an admittance control when the force control device according to the present invention was used.

Description of Embodiments

Hereinafter, an embodiment of the present invention will be described. The same elements are denoted by the same reference numerals throughout the embodiment.

(First Embodiment of the Present Invention)

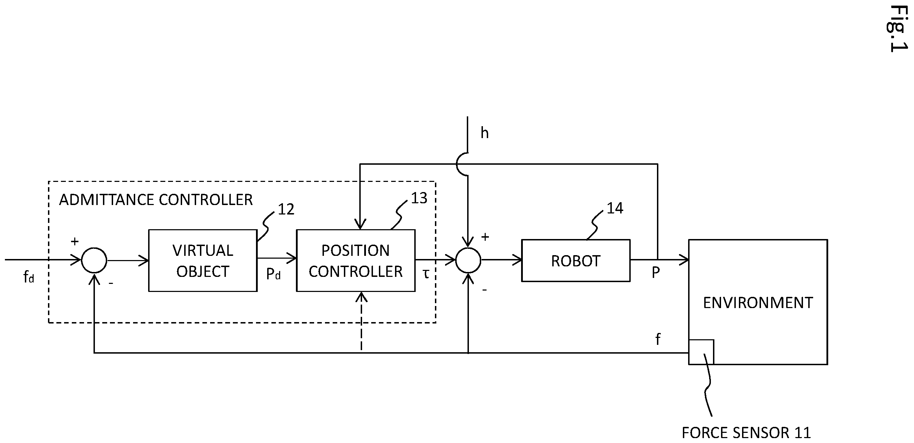

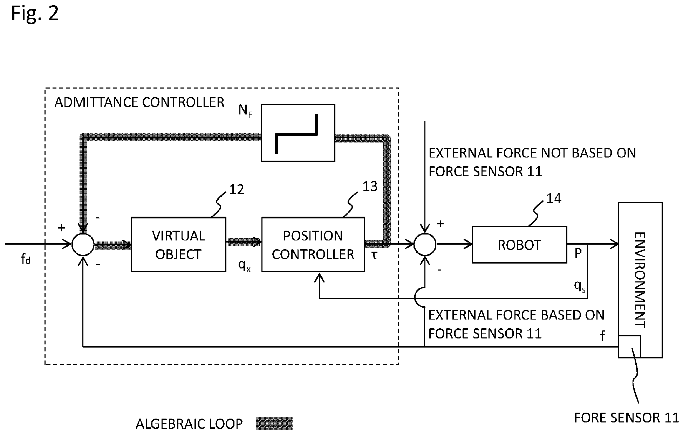

A force control device according to the present embodiment will be described with reference to FIGs. 1 to 5. FIG. 1 is a functional block diagram showing an example of a processing concept of a conventional force control device, and FIG. 2 is a functional block diagram showing an example of a processing concept of a force control device according to the present embodiment. As shown in FIG. 1, an admittance control in the prior art determines a position $P_d$ of a virtual object 12 having predetermined dynamic characteristics as a target position based on a measured value f of a force sensor 11 and a target force $f_d$ (a force applied to a robot 14 to be controlled). A position controller 13 calculates a torque command value $\tau$ of a motor of the robot 14 so as to satisfy the target position $P_d$. The robot 14 moves to a position P based on a force h applied to the robot 14 from the outside, the measured value f of the force sensor 11, and the torque command value $\tau$.

In the case of the prior art of FIG. 1, the target position $P_d$ of the virtual object 12 and the position P of the robot 14 will be deviated from each other when the torque command value $\tau$ is outside a torque range (for example, an upper limit value and a lower limit value of a torque set previously according to safety, drive characteristics of the robot 14, environment, and the like). In the prior art, it is necessary to make a transition from such a saturated state to an unsaturated state, which thus inevitably causes discomfort when the follow-up processing is performed. Therefore, in the present embodiment, the processing as shown in FIG. 2, for example, is performed.

In FIG. 2, the torque command value $\tau$ calculated by the position controller 13 is fed back in an algebraic loop, thereby making it possible to match the position $q_x$ of the virtual object 12 and the position $q_s$ of the robot 14, resulting in that it is possible to eliminate the discomfort in the follow-up processing as conventionally felt.

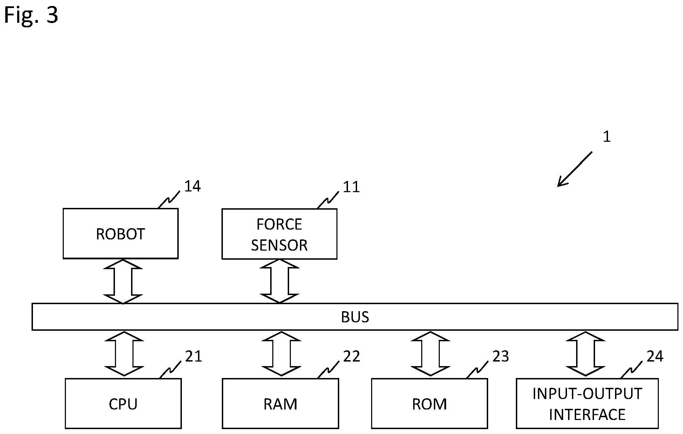

Hereinafter, a configuration and an algorithm of the force control device according to the present embodiment will be specifically described. FIG. 3 is a hardware configuration diagram of the force control device according to the present embodiment. A force control device 1 is provided with: the robot 14 to be controlled; the force sensor 11 that is attached to the robot 14 and measures a reaction force from an object in an environment around the robot 14; a ROM 23 that stores a program for performing admittance control, and the like; a CPU 21 that reads the program into a RAM 22 as needed, and executes a processing; and an input-output interface 24 that is an interface for accepting an input from an input device such as a touch panel, a keyboard, or a mouse, and outputting data to a printer, a display, or the like. These processing units are connected to each other via a bus and exchange information thereamong. The above hardware configuration is merely an example, and may be changed as needed.

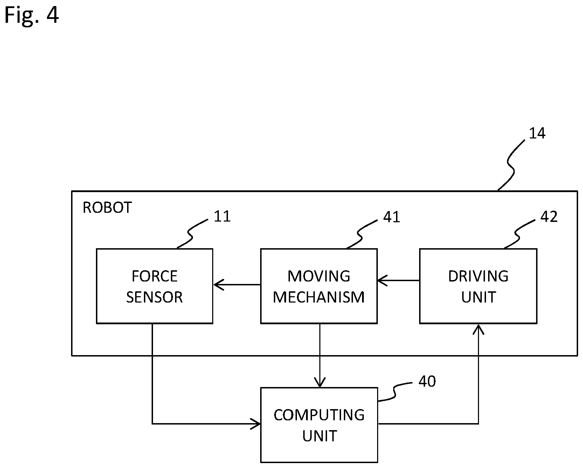

FIG. 4 is a functional block diagram of the force control device according to the present embodiment. The force control device 1 is provided with: the robot 14 that applies a predetermined force to an environment; and a computing unit 40 that controls a movement of the robot 14. The robot 14 is provided with: the force sensor 11 that measures the reaction force from the object in the surrounding environment; a moving mechanism 41 that moves the robot 14 or a part (such as, for example, an arm) of the robot 14; and a driving unit 42 that includes a motor for driving the moving mechanism 41. The computing unit 40 calculates a torque command value of the motor of the driving unit 42 based on a measurement result from the force sensor 11 and position information of the moving mechanism 41 and outputs the torque command value to the driving unit 42. The processing of calculating the torque command value by the computing unit 40 will be described in detail below.

(1) Mathematical Preparation

Let F be a closed interval on a real number. A saturation function and a normal cone therefor are defined as follows.

$$\text{sat}_{\mathcal{F}}(x) \overset{\Delta}{=} \underset{\xi \in \mathcal{F}}{\text{argmin}}(\xi - x)^2 \qquad (1)$$

$$\mathcal{N}_{\mathcal{F}}(x) \overset{\Delta}{=} \begin{cases} \{\xi \in \mathcal{R} \mid \xi(x^* - x) \leq 0 \ \forall x^* \in \mathcal{F}\} & \text{if } x \in \mathcal{F} \\ \emptyset & \text{if } x \notin \mathcal{F} \end{cases} \qquad (2)$$

The relationship between the saturation function and the normal cone is expressed as follows (Reference: Acary, V., Brogliato, B.: "Numerical Methods Nonsmooth Dynamical Systems", Applications in Mechanics and Electronics, Lecture Notes in Applied and Computational Mechanics, vol. 35. Springer (2008)).

$$x + \mathcal{N}_{\mathcal{F}}(x) \ni y \iff x = \text{sat}_{\mathcal{F}}(y) \qquad (3)$$

A sign function is defined as follows.

$$\text{sgn}(x) \overset{\Delta}{=} \begin{cases} [-1, 1] & \text{if } x = 0 \\ x/|x| & \text{if } x \neq 0 \end{cases} \qquad (4)$$

With respect to a closed interval [-F, F] defined by a positive constant F, the following holds.

$$\text{sat}_{[-F,F]}(x) = \begin{cases} x & \text{if } |x| \leq F \\ Fx/|x| & \text{if } |x| > F \end{cases} \qquad (5)$$

$$\mathcal{N}_{[-F,F]}(x) = \begin{cases} 0 & \text{if } |x| < F \\ [0, \infty) & \text{if } x = F \\ (-\infty, 0] & \text{if } x = -F \\ \emptyset & \text{if } |x| > F \end{cases} \qquad (6)$$

The sign function and the normal cone are inversely mapped to each other as described below.

$$x \in F\text{sgn}(y) \iff \mathcal{N}_{[-F,F]}(x) \ni y \qquad (7)$$

Further, the relationship between the sign function and the saturation function is expressed as follows.

$$x \in F\text{sgn}(y - x) \iff x = \text{sat}_{[-F,F]}(y) \qquad (8)$$

(2) Next, a general expression of the proposed control rule will be described.

(2.1) Continuous Time Expression

Let the actual position of the control target (robot 14) be $q_s$, the position of the virtual object 12 be $q_x$, the generated force in the driving device 42 be $\tau$, the measured value of the force sensor 11 be f, and the target force given to the admittance controller be $f_d$ (which may be fixed as $f_d = 0$).

Further, the position control rule of the robot 14 when the target position is let be $q_x$ is given by an appropriate function $\Phi_c$, as follows.

$$\tau = \Phi_c \left( q_x, q_s, \dot{q}_x, \dot{q}_s, \ddot{q}_x, \int (q_x - q_s)dt \right) \qquad (9)$$

Further, the dynamic characteristics to be realized by the virtual object are given by an appropriate function $\Gamma_c$, as follows.

$$\Gamma_c(\ddot{q}_x, \dot{q}_x, q_x) = f + f_d \qquad (10)$$

Specific examples of these functions will be described later in section (3).

Letting the allowable range of the generated force $\tau$ of the driving device 4 be a set F, the continuous time expression of the proposed controller is expressed as follows.

$$\Gamma_c(\ddot{q}_x, \dot{q}_x, q_x) - f - f_d \in -\mathcal{N}_{\mathcal{F}}(\tau) \qquad (11a)$$

$$\tau = \Phi_c \left( q_x, q_s, \dot{q}_x, \dot{q}_s, \ddot{q}_x, \int (q_x - q_s)dt \right) \qquad (11b)$$

This can be regarded as a simultaneous differential equation in which $\tau$ and $q_x$ (second order differential) are unknown. Also, this can be represented as a block diagram including an algebraic loop as shown in FIG. 2. Although the normal cone $N_f(.)$ in the equation (11a) is an argument, $\tau$ is not allowed to exist outside F, so that $\tau$ must be within F to satisfy the above. It can be interpreted that $q_x$ is updated (i.e., $q_x$ (second order differential) is determined) such that $\tau$ should be within F. If the generated force $\tau$ calculated when $q_x$ (second order differential) is determined so as to satisfy the expression (10) and is then substituted into the expression (11b) is within F, a value of this $\tau$ is adopted as it is. On the other hand, if this $\tau$ is outside F, $\tau$ saturates at the value closest to $\tau$ on the boundary of F, and in this case, $q_x$ (second order derivative) is determined so as to satisfy the expression (11b).

(2.2) Discrete Time Expression (Expression Including Algebraic Loop)

A discrete time expression of the controller (11) will be derived.

When the discretization as

$$\dot{q} \approx \big(q(k) - q(k-1)\big)/T$$

is made, the equation (11a) can be re-written using an appropriate function $\Gamma$, as follows.

$$q_x(k) \in \Gamma(q_x(k-1), q_x(k-2), f(k) + f_d(k)) - \mathcal{N}_{\mathcal{F}}(\tau(k)) \qquad (12a)$$

Further, the equation (11b) can be re-written using an appropriate function $\Phi$, as

$$\tau(k) = \Phi(q_x(k), q_s(k), \mathcal{S}(k-1)) \qquad (12b)$$

where S(k-1) is a set including, for example, an integral term, a measured position $q_s$(k-1) of a preceding step, and a target position $p_d$(k-1) of the preceding step. The output value $\tau$(k) of this function is set as a torque command value to a motor.

Using yet another function $\Phi_s$, S(k) in the next step is determined as follows.

$$\mathcal{S}(k) = \Phi_S(q_x(k), q_s(k), \mathcal{S}(k-1)) \qquad (13)$$

This S (k) is used as one of input values S(k-1) in the next step.

The equations (12a) and (12b) can be regarded as simultaneous equations for the unknowns $\tau$(k) and $q_x$(k), which can also be interpreted as the block diagram as shown in FIG. 2. Using these, the proposed admittance control algorithm is expressed as follows.

$$q_x^*(k) := \Gamma(q_x(k-1), q_x(k-2), f(k) + f_d(k)) \qquad (14a)$$

$$\{\tau(k), q_x(k)\} := \text{solution of} \left\{ \begin{array}{l} \mathcal{N}_{\mathcal{F}}(\tau(k)) \ni q_x^*(k) - q_x(k) \\ \tau(k) = \Phi(q_x(k), q_s(k), \mathcal{S}(k-1)) \end{array} \right\} \qquad (14b)$$

$$\mathcal{S}(k) := \Phi_S(q_x(k), q_s(k), \mathcal{S}(k-1)) \qquad (14c)$$

Since these expressions include a step of solving the algebraic inclusive expression (14b), it is difficult to implement them as they are.

(2.3) Discrete Time Expression (Expression as Algorithm)

A method of solving the algebraic inclusive expression (14b) will be considered. Here, the following assumption is made.

Assumption 1: The function $\Phi(q_x, q_s, S)$ is strictly a monotonical increasing with respect to the argument $q_x$. Many typical controllers satisfy this assumption.

It is clear that the following expression holds under this assumption.

$$\left\{ \begin{array}{l} \Phi(q_x^*, q_s, \mathcal{S}) - \Phi(q_x, q_s, \mathcal{S}) > 0 \iff q_x^* - q_x > 0 \\ \Phi(q_x^*, q_s, \mathcal{S}) - \Phi(q_x, q_s, \mathcal{S}) = 0 \iff q_x^* - q_x = 0 \\ \Phi(q_x^*, q_s, \mathcal{S}) - \Phi(q_x, q_s, \mathcal{S}) < 0 \iff q_x^* - q_x < 0 \end{array} \right. \qquad (15)$$

Further, under this assumption, it is clear that there exists a single-valued function $\Phi_{inv}$ that satisfies the following.

$$\tau = \Phi(q_x, q_s, \mathcal{S}) \iff q_x = \Phi_{\text{inv}}(\tau, q_s, \mathcal{S}) \qquad (16)$$

This function $\Phi_{inv}$ can be called an inverse controller. An ordinary controller gives a torque command value to a target position. In contrast, the reverse controller calculates a target position required to output a designated torque command value. The algebraic inclusive expression given by the expression (14b) can be re-written using the expression (15), as

$$\mathcal{N}_{\mathcal{F}}(\tau(k)) \ni \Phi(q_x^*(k), q_s(k), \mathcal{S}(k-1)) - \Phi(q_x(k), q_s(k), \mathcal{S}(k-1)) \qquad (17)$$

$$\tau(k) = \Phi(q_x(k), q_s(k), \mathcal{S}(k-1)) \tag{18}$$

Here, it is considered that there are only three possible return values of the normal cone $NF(\tau(k))$: $(-\infty, 0]$, $0$, $[0, \infty)$. From the expression (8), the above expressions become as follows.

$$\tau(k) = \mathrm{sat}_{\mathcal{F}}\left(\Phi(q_x^*(k), q_s(k), \mathcal{S}(k-1))\right) \tag{19}$$

$$\tau(k) = \Phi(q_x(k), q_s(k), \mathcal{S}(k-1)) \tag{20}$$

Here, the expression (20) can be re-written using the inverse controller $\Phi_{\mathrm{inv}}$ defined by the expression (16), as follows.

$$q_x(k) = \Phi_{\mathrm{inv}}(\tau(k), q_s(k), \mathcal{S}(k-1)) \tag{21}$$

Therefore, the algorithm of the expression (14) can be re-written as follows.

$$q_x^*(k) := \Gamma(q_x(k-1), q_x(k-2), f(k) + f_d(k)) \tag{22a}$$

$$\tau^*(k) := \Phi(q_x^*(k), q_s(k), \mathcal{S}(k-1)) \tag{22b}$$

$$\tau(k) := \mathrm{sat}_{\mathcal{F}}\left(\tau^*(k)\right) \tag{22c}$$

$$q_x(k) := \Phi_{\mathrm{inv}}(\tau(k), q_s(k), \mathcal{S}(k-1)) \tag{22d}$$

$$\mathcal{S}(k) := \Phi_S(q_x(k), q_s(k), \mathcal{S}(k-1)) \tag{22e}$$

The above expression is one form of the proposed admittance control algorithm. This algorithm can be further simplified when the following assumption 2 is satisfied in addition to the assumption 1.
Assumption 2: There exist a positive constant $\hat{K}$ and a function $\Phi_p(q_s, S)$ that satisfy $\Phi(q_x, q_s, S) = \hat{K}(q_x - \Phi_p(q_s, S))$ for all of $q_x$, $q_s$, and S.
This means that the controller $\Phi(q_x, q_s, S)$ is linear with respect to the target value $q_x$, and many typical controllers $\Phi(q_x, q_s, S)$ satisfy this assumption. In this case, the inverse controller function becomes as follows.

$$\Phi_{\mathrm{inv}}(\tau, q_s, \mathcal{S}) = \Phi_p(q_s, \mathcal{S}) + \tau/\hat{K} \tag{23}$$

And, the algorithm (22) becomes as follows.

$$q_x^*(k) := \Gamma(q_x(k-1), q_x(k-2), f(k) + f_d(k)) \tag{24a}$$

$$q_s^*(k) := \Phi_p(q_s(k), \mathcal{S}(k-1)) \tag{24b}$$

$$\tau^*(k) := \hat{K}(q_x^*(k) - q_s^*(k)) \tag{24c}$$

$$\tau(k) := \mathrm{sat}_{\mathcal{F}}(\tau^*(k)) \tag{24d}$$

$$q_x(k) := q_s^*(k) + \tau^*(k)/\hat{K} \tag{24e}$$

$$\mathcal{S}(k) := \Phi_S(q_x(k), q_s(k), \mathcal{S}(k-1)) \tag{24e}$$

The operation of the expression (22d) in the algorithm (22) is simplified as that of the expression (24e) in the algorithm (24). Therefore, the amount of calculation can be reduced by implementing the type of the algorithm (24), depending on the structure of the function Φ().

(3) Next, actual examples of the functions $\Phi_c$ and $\Gamma_c$ will be described.

(3.1) Example of Function $\Phi_c$: In the Case of PID Control with Target Acceleration Feedforward

In the case of a PID control with a target acceleration feedforward, the controller function $\Phi_c$ in the continuous time domain is given as

$$\Phi_c\left(q_x, q_s, \dot{q}_x, \dot{q}_s, \ddot{q}_x, \int(q_x - q_s)dt\right) \triangleq M\ddot{q}_x + K(q_x - q_s) + B(\dot{q}_x - \dot{q}_s) + L\int(q_x - q_s)dt \tag{25}$$

where $Mq_x$ ($q_x$ is the second order differential) is the feedforward term of a target acceleration, and K, B, and L are proportional, differential, and integral gains, respectively.
In this case, the following expression

$$\tau = \Phi_c\left(q_x, q_s, \dot{q}_x, \dot{q}_s, \ddot{q}_x, \int(q_x - q_s)dt\right) \tag{26}$$

can be discretized to form into the following expression.

$$\begin{aligned}\tau(k) &= M\frac{q_x(k) - 2q_x(k-1) + q_x(k-2)}{T^2} + K(q_x(k) - q_s(k)) \\ &\quad + B\frac{q_x(k) - q_x(k-1) - q_s(k) + q_s(k-1)}{T} + L(a(k-1) + T(q_x(k) - q_s(k))) \\ &= (\hat{A} + M/T^2)(q_x(k) - q_s^*(k))\end{aligned} \tag{27}$$

Here, a corresponds to $a = \int(qx - q_s)dt$, and is as follows.

$$a(k) = a(k-1) + T(q_x(k) - q_s(k)) \tag{28}$$

Further, $A = K + B/T + LT$ and the following expression holds.

$$q_s^*(k) = \frac{\hat{A}q_s(k) + B(q_x(k-1) - q_s(k-1))/T - La(k-1)}{\hat{A} + M/T^2} + \frac{M(2q_x(k-1) - q_x(k-2))}{\hat{A}T^2 + M} \quad (29)$$

Considering these, the functions $\Phi$, $\Phi_S$, and $\Phi_{inv}$ that correspond to the above function $\Phi_c$ become as follows.

$$\Phi(q_x, q_s, \mathcal{S}) \triangleq \text{Function} \Big[$$
$$\{q_{x1}, q_{x2}, q_{s1}, a_1\} := \mathcal{S}$$
$$q_s^* := \frac{\hat{A}q_s + B(q_{x1} - q_{s1})/T - La_1}{\hat{A} + M/T^2} + \frac{M(2q_{x1} - q_{x2})}{\hat{A}T^2 + M}$$
$$\text{Return } (\hat{A} + M/T^2)(q_x - q_s^*) \Big] \quad (30)$$

$$\Phi_S(q_x, q_s, \mathcal{S}) \triangleq \text{Function} \Big[$$
$$\{q_{x1}, q_{x2}, q_{s1}, a_1\} := \mathcal{S}$$
$$\text{Return } \{q_x, q_{x1}, q_s, a_1 + T(q_x - q_s)\} \Big] \quad (31)$$

$$\Phi_{inv}(\tau, q_s, \mathcal{S}) \triangleq \text{Function} \Big[$$
$$\{q_{x1}, q_{x2}, q_{s1}, a_1\} := \mathcal{S}$$
$$q_s^* := \frac{\hat{A}q_s + B(q_{x1} - q_{s1})/T - La_1}{\hat{A} + M/T^2} + \frac{M(2q_{x1} - q_{x2})}{\hat{A}T^2 + M}$$
$$\text{Return } q_s^* + \tau/(\hat{A} + M/T^2) \Big] \quad (32)$$

Further, the above function $\Phi()$ clearly satisfies the assumption 2, so that the function $\Phi_p$ can be determined as follows.

$$\Phi_p(q_s, \mathcal{S}) \triangleq \text{Function} \Big[$$
$$\{q_{x1}, q_{x2}, q_{s1}, a_1\} := \mathcal{S} \quad (33)$$
$$\text{Return } \frac{\hat{A}q_s + B(q_{x1} - q_{s1})/T - La_1}{\hat{A} + M/T^2} + \frac{M(2q_{x1} - q_{x2})}{\hat{A}T^2 + M} \Big]$$

Therefore, this function can be implemented in a form of the algorithm (24). A result of this implementation is as follows.

$$q_r^*(k) := \Gamma(q_x(k-1), q_x(k-2), f(k) + f_d(k))$$

$$q_s^*(k) = \frac{\hat{A}q_s(k) + B(q_x(k-1) - q_s(k-1))/T - La(k-1)}{\hat{A} + M/T^2} + \frac{M(2q_x(k-1) - q_x(k-2))}{\hat{A}T^2 + M}$$

$$\tau^*(k) := (\hat{A} + M/T^2)(q_r^*(k) - q_s^*(k))$$

$$\tau(k) := \mathrm{sat}_{\mathcal{T}}(\tau^*(k)) \tag{34}$$

$$q_x(k) := q_s^*(k) + \tau(k)/(\hat{A} + M/T^2)$$

$$a(k) := a(k-1) + T(q_x(k) - q_s(k))$$

(3.2) Example of Function $\Gamma_c$: In the Case of Mass-Damper System

When dynamic characteristics of a virtual object are given by a simple inertial-viscous system, the dynamic characteristics becomes as follows.

$$M_v \ddot{q}_x + B_v \dot{q}_x = f + f_d \tag{35}$$

Therefore, the function $\Gamma_c$ becomes as follows.

$$\Gamma_c(\ddot{q}_x, \dot{q}_x, q_x) \triangleq M_v \ddot{q}_x + B_v \dot{q}_x \tag{36}$$

Here, when the expression (35) is discretized, it becomes as follows.

$$\frac{M_v}{T^2}(q_x(k) - 2q_x(k-1) + q_x(k-2)) + \frac{B_v}{T}(q_x(k) - q_x(k-1)) - f(k) - f_d(k) = 0 \tag{37}$$

Solving this expression for $q_x(k)$ gives the following.

$$q_x(k) = \frac{(2M_v + B_v)q(k-1) + M_v q_x(k-2) + T^2(f(k) + f_d(k))}{M_v + B_v T} \tag{38}$$

That is, the function $\Gamma$ becomes as follows.

$$\Gamma(q_1, q_2, f) \triangleq \frac{(2M_v + B_v)q_1 - M_v q_2 + T^2 f}{M_v + B_v T} \tag{39}$$

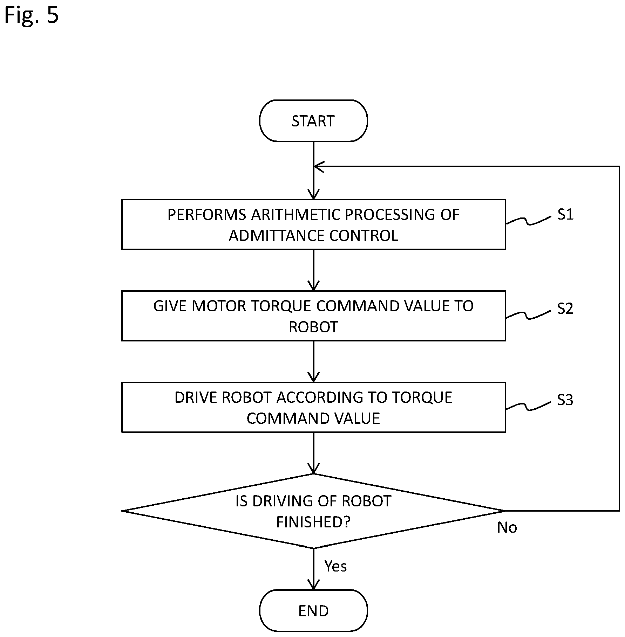

Next, the operation of the force control device according to the present embodiment will be described. FIG. 5 is a flowchart illustrating the operation of the force control device according to the present embodiment. First, the computing unit 40 performs arithmetic processing of the admittance control based on the force applied from the outside to the robot 14 and the measured value of the force sensor 11 (S1). This arithmetic processing is as described above. As a result of the calculation, a motor torque command value for driving the robot 14 is outputted and inputted to the robot 14 (S2). The robot 14 is driven according to the torque command value (S3). When the driving of the robot 14 finishes, the processing is terminated. When the driving (including a stopped state) continues, as a result of the driving, the position of the robot 14 and the measured value of the force sensor 11 are outputted, and the process returns to the arithmetic processing of the admittance control in step S1. Thereafter, the same processing is repeated.

As described above, in the force control device according to the present embodiment, when the calculated torque is outside the predetermined range set previously, the position of the virtual object at the next time is determined using the algebraic loop based on the boundary value of the predetermined range and the torque command value, so that positional deviation between the virtual object and the control target is reduced, resulting in that it is possible to improve stability while improving followability.

Example

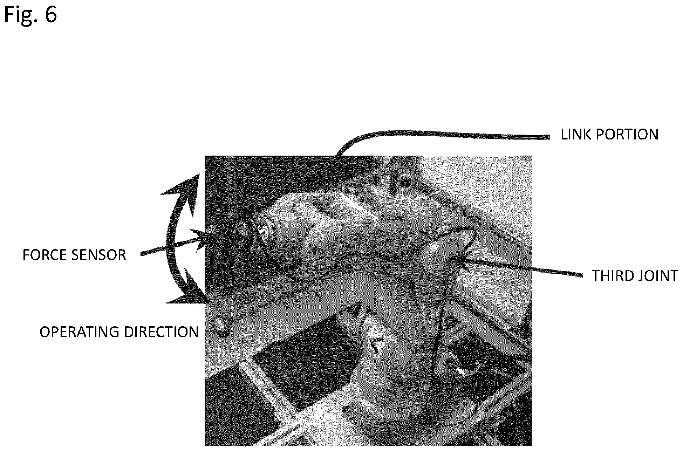

With respect to the force control device according to the present invention, the following experiment was performed. FIG. 6 is a photograph of the robot 14 used in the experiment. The above-mentioned admittance control rule was implemented in the third joint of the robot 14, and the other joints were locked. Then, the behavior when the operation was performed by contacting the force sensor 11 and the behavior when the operation was performed by contacting a link portion (a portion other than the force sensor 11) were observed.

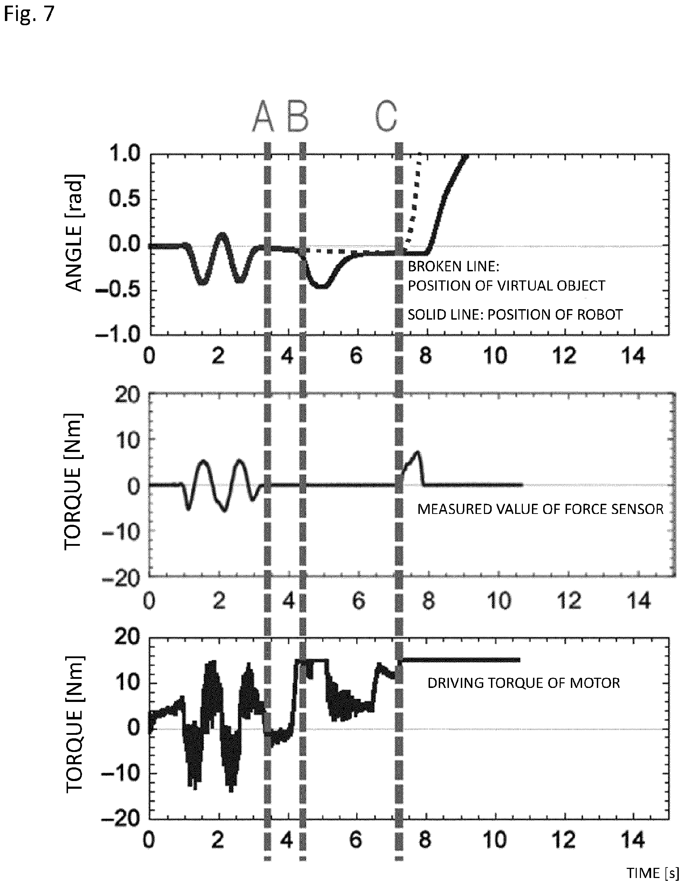

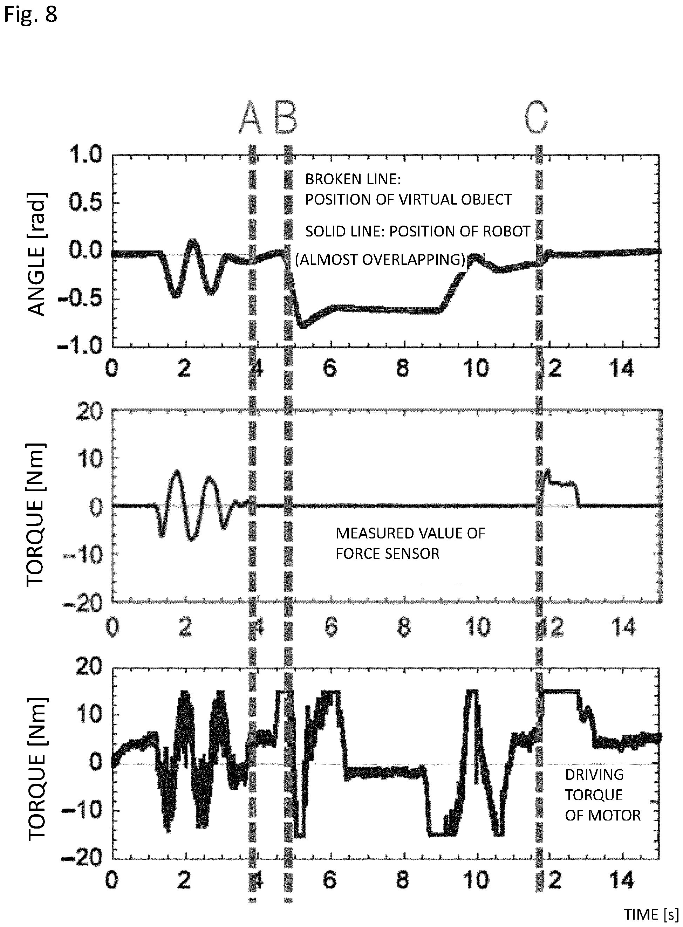

FIG. 7 is a diagram showing a result of an admittance control when a conventional method was used, and FIG. 8 is a diagram showing a result of an admittance control when the force control device according to the present invention was used. In FIGs. 7 and 8, measurement results are shown for the respective states as follows:

(1) to time A: operated with the force sensor 11 held by hand;
(2) from time B to time C: a state in which a force was applied to a place outside the force sensor 11; and
(3) From time C: a state in which a force was applied to the force sensor 11 while the link portion was fixed by hand such that the robot 14 did not move.

The top of the graph shows the position of the virtual object 12 and the position of the robot 14, the middle shows the measured value of the force sensor 11, and the bottom shows the driving torque of the motor.

As can be seen from FIGs. 7 and 8, in the state (1), the position of the robot 14 follows the position of the virtual object 12 well in any of the methods. In the state (2), according to the conventional method of FIG. 7, the position of the robot 14 and the position of the virtual object 12 are deviated from each other. In this case, the position will tend to return to the original position like a spring when the applied force is released, which might be dangerous. On the other hand, according to the method of the present invention in FIG. 8, the position of the virtual object 12 follows the position of the robot 14, so that there would be no such a danger at all even when the applied force is released. In the state (3), according to the conventional method shown in FIG. 7, only the position of the virtual object 12 moves. In this case, the robot 14 will tend to follow the position of the far-away virtual object 12 when the user releases his/her hand, which might be dangerous. On the other hand, according to the method of the present application in FIG. 8, the position of the virtual object 12 does not move and the position of the robot 14 does not move either, so that there would be no such a danger at all.

As described above, it has been revealed that the method of the present invention has significantly improved safety as compared with the conventional method in such a situation where the torque saturation occurs.

Reference Signs List

1    Force Control Device
11   Force Sensor
12   Virtual Object
13   Position Controller
14   Robot
21   CPU
22   RAM
23   ROM
24   Input-Output Interface
40   Computing Unit
41   Moving Mechanism
42   Drive Unit

**Claims**

**1.**   A force control device comprising:

a position detector that detects a position of a control target;
a force sensor that detects a force by which the control target is in contact with an object;

a moving mechanism that movably holds the control target;
a driving unit that includes a motor that uses a torque command value as an input to operate the moving mechanism; and
a computing unit that determines the torque command value, wherein
the computing unit stores a virtual object having predetermined dynamic characteristics, and a position control rule, and is configured to:

calculate a position at a next time, the position being calculated by simulating a motion of the virtual object when a target force exerted on the control target and a measured value of the force sensor are given to the virtual object;
obtain a torque calculated when the calculated position is given to the position control rule as a target position at the next time;
when the obtained torque is within a predetermined range set previously, determine the obtained torque as the torque command value to determine the calculated position as a position of the virtual object at the next time; and
when the obtained torque is outside the predetermined range set previously, determine the position of the virtual object at the next time based on a boundary value of the predetermined range and the obtained torque.

2. The force control device according to claim 1, wherein the computing unit is configured to, when the obtained torque is outside the predetermined range set previously, determine a torque on a boundary of the predetermined range and closest to the obtained torque, as the torque command value, calculate the target position at the next time when a torque command value calculated by the position controller becomes the determined torque command value, and determine the calculated target position as the position of the virtual object at the next time.

3. The force control device according to claim 2, wherein the computing unit is configured to determine, in a continuous time, the torque $\tau$ by updating the position $q_x$ of the virtual object so as to satisfy

$$\Gamma_c(\ddot{q}_x, \dot{q}_x, q_x) - f - f_d \in -\mathcal{N}_{\mathcal{F}}(\tau)$$

$$\tau = \Phi_c\left(q_x, q_s, \dot{q}_x, \dot{q}_s, \ddot{q}_x, \int (q_x - q_s)dt\right)$$

where F is the predetermined torque range, $q_s$ is an actual position of the control target, $f_d$ is the target force, f is the measured value of the force sensor, the predetermined dynamic characteristics of the virtual object is represented using a certain function $\Gamma_c$ as

$$\Gamma_c(\ddot{q}_x, \dot{q}_x, q_x) = f + f_d$$

and it is assumed that a function $\Phi_c$ is a position controller defined such that $q_s$ follows a target value of $q_x$.

4. The force control device according to claim 2, wherein the computing unit is configured to determine, at a time k in a discrete time, determine $q_x(k)$ and $\tau(k)$ so as to satisfy

$$q_x(k) \in \Gamma(q_x(k-1), q_x(k-2), f(k) + f_d(k)) - \mathcal{N}_{\mathcal{F}}(\tau(k))$$

$$\tau(k) = \Phi\left(q_x(k), q_s(k), \mathcal{S}(k-1)\right)$$

where $\tau$ is the torque, F is the predetermined torque range, $q_x$ is the position of the virtual object, $q_s$ is an actual position of the control target, $f_d$ is the target force, f is the measured value of the force sensor, the predetermined dynamic characteristics of the virtual object is represented using a certain function $\Gamma_c$ as

$$q_x(k) = \Gamma(q_x(k-1), q_x(k-2), f(k) + f_d(k))$$

and it is assumed that a function $\Phi$ is a position controller defined such that $q_s$ follows a target value of $q_x$ and that an output $\tau(k)$ of this function is determined as the torque command value, where S(k-1) is a set of state variables, stored in a controller, such as an integral term, a measured position $p_s$(k-1) in a preceding step, and a target position $p_d$(k-1) in the preceding step.

5. The force control device according to claim 4, wherein the function $\Gamma$ is given by a function having an input-output relation as

$$\Gamma(q_1, q_2, f) \triangleq \frac{(2M_v + B_v)q_1 - M_v q_2 + T^2 f}{M_v + B_v T}$$

where T, $M_v$, and $B_v$ are positive constants.

6. The force control device according to claim 4, wherein the function $\Phi$ is a function having a same input-output relation as in an algorithm as

$$\Phi(q_x, q_s, \mathcal{S}) \triangleq \text{Function}\left[\begin{array}{l} \{q_{x1}, q_{x2}, q_{s1}, a_1\} := \mathcal{S} \\[2mm] q_s^* := \dfrac{\hat{A}q_s + B(q_{x1} - q_{s1})/T - La_1 + M(2q_{x1} - q_{x2})/T^2}{\hat{A} + M/T^2} \\[2mm] \tau := (\hat{A} + M/T^2)(q_x - q_s^*) \\[2mm] \text{return } \tau \end{array}\right.$$

where $\hat{A}$, B, L, M, and T are positive constants.

7. The force control device according to claim 4, wherein the calculation for determining $q_x$(k) and $\tau$(k) has a same input-output relation as in an algorithm as follows.

$$q_x^*(k) := \Gamma(q_x(k-1), q_x(k-2), f(k) + f_d(k))$$

$$q_s^*(k) := \Phi_p(q_s(k), \mathcal{S}(k-1))$$

$$\tau^*(k) := \hat{K}(q_x^*(k) - q_s^*(k))$$

$$\tau(k) := \text{sat}_{\mathcal{F}}(\tau^*(k))$$

$$q_x(k) := q_s^*(k) + \tau^*(k)/\hat{K}$$

$$\mathcal{S}(k) := \Phi_S(q_x(k), q_s(k), \mathcal{S}(k-1))$$

**8.** A force control method performed by a computer, the method comprising:

a position detecting step of detecting a position of a control target;
a force detecting step of detecting a force by which the control target is in contact with an object;
a computing step of computing a torque command value for a driving unit that includes a motor that uses the torque command value as an input to operate the moving mechanism; and
a moving step of moving the control target based on a computation result of the computing step, wherein the computing step comprises:

calculating a position at a next time, the position being calculated by simulating a motion of a virtual object when a target force exerted on the control target and a measured value of the force detecting step are given to the virtual object, using the virtual object and a position control rule that are stored in the computer, the virtual object having predetermined dynamic characteristics;
obtaining a torque calculated when the calculated position is given to the position control rule as a target position at the next time;
when the obtained torque is within a predetermined range set previously, determining the obtained torque as the torque command value to determine the calculated position as a position of the virtual object at the next time; and
when the obtained torque is outside the predetermined range set previously, determining the position of the virtual object at the next time based on a boundary value of the predetermined range and the obtained torque.

**9.** A force control program that makes a computer to function as:

position detecting means for detecting a position of a control target;
force detecting means for detecting a force by which the control target is in contact with an object;
computing means for computing a torque command value for a driving unit that includes a motor that uses the torque command value as an input to operate the moving mechanism; and
moving control means for controlling a movement of the control target based on a computation result of the computing means, wherein the computing means:

calculates a position at a next time, the position being calculated by simulating a motion of the virtual object when a target force exerted on the control target and a measured value of the force detecting step are given to the virtual object, using the virtual object and a position control rule that are stored in the computer, the virtual object having predetermined dynamic characteristics;
obtains a torque calculated when the calculated position is given to the position control rule as a target position at the next time;
when the obtained torque is within a predetermined range set previously, determines the obtained torque as the torque command value to determine the calculated position as a position of the virtual object at the next time; and
when the obtained torque is outside the predetermined range set previously, determines the position of the virtual object at the next time based on a boundary value of the predetermined range and the obtained torque.

Fig.1

ADMITTANCE CONTROLLER

VIRTUAL OBJECT 12

POSITION CONTROLLER 13

ROBOT 14

ENVIRONMENT

FORCE SENSOR 11

$f_d$

$P_d$

$\tau$

$h$

$P$

$f$

+ − + − +

Fig. 2

ADMITTANCE CONTROLLER  N_F

EXTERNAL FORCE NOT BASED ON FORCE SENSOR 11

12

13

14

+  −

VIRTUAL OBJECT

POSITION CONTROLLER

ROBOT

ENVIRONMENT

f_d

−

q_x

τ

+

−

P

q_s

EXTERNAL FORCE BASED ON FORCE SENSOR 11

f

FORE SENSOR 11

ALGEBRAIC LOOP

Fig. 3

Fig. 4

```
                                                                    ⌇14
┌─────────────────────────────────────────────────────────────────────┐
│ ROBOT                                                                 │
│                ⌇11              ⌇41              ⌇42                   │
│       ┌──────────────┐  ┌──────────────┐  ┌──────────────┐            │
│       │    FORCE     │←─│   MOVING     │←─│   DRIVING    │            │
│       │    SENSOR    │  │  MECHANISM   │  │     UNIT     │            │
│       └──────────────┘  └──────────────┘  └──────────────┘            │
│             │                  │                  ↑                    │
└─────────────┼──────────────────┼──────────────────┼───────────────────┘
              │                  ↓                  │
              │          ┌──────────────┐  ⌇40      │
              └─────────→│  COMPUTING   │───────────┘
                         │     UNIT     │
                         └──────────────┘
```

Fig. 5

```
                    ┌──────────────┐
                    │    START     │
                    └──────┬───────┘
                           │
                           ▼
        ┌──────────────────────────────────┐
        │  PERFORMS ARITHMETIC PROCESSING OF │ ∿  S1
        │       ADMITTANCE CONTROL           │
        └──────────────────┬─────────────────┘
                           │
                           ▼
        ┌──────────────────────────────────┐
        │  GIVE MOTOR TORQUE COMMAND VALUE TO │ ∿  S2
        │              ROBOT                 │
        └──────────────────┬─────────────────┘
                           │
                           ▼
        ┌──────────────────────────────────┐
        │   DRIVE ROBOT ACCORDING TO TORQUE  │ ∿  S3
        │          COMMAND VALUE             │
        └──────────────────┬─────────────────┘
                           │
                           ▼
                ◇─────────────────────◇
               │   IS DRIVING OF ROBOT  │─── No ──┐
               │      FINISHED?         │         │
                ◇─────────────────────◇          │
                           │                      │
                          Yes                     │
                           ▼                      │
                    ┌──────────────┐              │
                    │     END      │              │
                    └──────────────┘              │
```

Fig. 6

LINK PORTION

FORCE SENSOR

OPERATING DIRECTION

THIRD JOINT

Fig. 7

BROKEN LINE:
POSITION OF VIRTUAL OBJECT

SOLID LINE: POSITION OF ROBOT

MEASURED VALUE OF FORCE SENSOR

DRIVING TORQUE OF MOTOR

TIME [s]

Fig. 8

| | | International application No. |
|---|---|---|
| **INTERNATIONAL SEARCH REPORT** | | PCT/JP2018/025338 |

**A. CLASSIFICATION OF SUBJECT MATTER**
Int.Cl. G05B17/02(2006.01)i

According to International Patent Classification (IPC) or to both national classification and IPC

**B. FIELDS SEARCHED**

Minimum documentation searched (classification system followed by classification symbols)
Int.Cl. G05B17/02

Documentation searched other than minimum documentation to the extent that such documents are included in the fields searched
| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 6032811 B2 (KYUSHU UNIVERSITY) 30 November 2016, entire text, all drawings (Family: none) | 1-9 |
| A | 菊植亮，水谷考樹，アドミッタンス制御の内部位置制御におけるプロクシベースト・スライディングモード制御の有効性，第29回日本ロボット学会学術講演会予稿集 DVD-ROM 2011年 The 29th Annual Conference of the Robotics Society of Japan, 一般社団法人日本ロボット学会， 07 September 2011, 1446-1449, non-official translation (KIKUUE, Ryo, MIZUTANI, Koki, "Effectiveness of proxy-based sliding mode control in controlling inner position of admittance control", The Robotics Society of Japan) | 1-9 |

☒ Further documents are listed in the continuation of Box C.  ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 November 2018 (21.11.2018) | 04 December 2018 (04.12.2018) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

| International application No. |
| --- |
| PCT/JP2018/025338 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2009-66696 A (TOYOTA MOTOR CORP.) 02 April 2009, entire text, all drawings & US 2010/0262291 A1 | 1-9 |
| A | JP 2009-208170 A (TOYOTA MOTOR CORP.) 17 September 2009, entire text, all drawings (Family: none) | 1-9 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007102748 A

- JP 6032811 B

**Non-patent literature cited in the description**

- **D. E. WHITNEY.** Historical perspective and state of the art in robot force control. *Int. J. Robotics Research,* 1987, vol. 6 (1), 3-14
- **G. ZENG ; A. HEMAMI.** An overview of robot force control. *Robotica,* 1997, vol. 15, 473-482
- **C. OTT ; R. MUKHERJEE ; Y. NAKAMURA.** Unified impedance and admittance control. *Proc. IEEE Int. Conf. Robotics and Automation,* 2010, 554-561
- **M. UEBERLE ; M. BUSS.** Control of kinesthetic haptic interfaces. *Proc. Workshop on Touch and Haptics, IEEE/RSJ Int. Conf. Intelligent Robots and Systems,* 2004, 1-14
- **R. Q. VAN DER LINDE ; P. LAMMERTSE.** Haptic-Master - ageneric force controlled robot for human interaction. *Industrial Robot,* 2003, vol. 30 (6), 515-524
- **A. PEER ; M. BUSS.** A new admittance-type haptic interface for bimanual manipulations. *IEEE/ASME Trans. Mechatronics,* 2008, vol. 13 (4), 416-428
- **P. R. CULMER ; A. E. JACKSON ; S. MAKOWER ; R. RICHARDSON ; J. A. COZENS ; M. C. LEVESLEY ; B. B. BHAKTA.** A control strategy for upper limb robotic rehabilitation with a dual robot system. *IEE E/ASME Trans. Mechatronics,* 2010, vol. 15 (4), 575-585
- **N. TAKESUE ; H. MURAYAMA ; K. FUJIWARA ; K. MATSUMOTO ; H. KONOSU ; H. FUJIMOTO.** Kinesthetic assistance for improving task performance - the case of window installation assist. *Int. J. Automation Technology,* 2009, vol. 3 (6), 663-670
- **H. ARAI.** Force-controlled metal spinning machine using linear motors. *Proc. IEEE Int. Conf. Robotics and Automation,* 2006, 4031-4036
- **R. KIKUUWE ; S. YASUKOUCHI ; H. FUJIMOTO ; M. YAMAMOTO.** Proxybased sliding mode control: A safer extension of PID position control. *IEEE Trans. Robotics,* 2010, vol. 26 (4), 860-873
- **J. DE SCHUTTER.** A study of active compliant motion control methods for rigid manipulators based on a generic scheme. *Proc. IEEE Int. Conf. Robotics and Automation,* 1987, vol. 4, 1060-1065

- **H. ISHIKAWA ; C. SAWADA ; K. KAWASE ; M. TAKATA.** Stable compliance control and its implementation for a 6 DOF manipulator. *Proc. IEEE Int. Conf. Robotics and Automation,* 1989, vol. 1, 98-103
- **H. SERAJI.** Adaptive admittance control: an approach to explicit force control in compliant motion. *Proc. IEEE Int. Conf. Robotics and Automation,* 1994, 2705-2712
- **D. E. WHITNEY.** Force feedback control of manipulator fine motions. *Trans. ASME: J. Dynamic Systems, Measurement, and Control,* 1977, vol. 99 (2), 91-97
- **G. HIRZINGER.** Direct digital robot control using a force-torque sensor. *Proc. IFAC Symp. Real Time Digital Control Applications,* 1983, 243-255
- **J. DE SCHUTTER ; H. VAN BRUSSEL.** A methodology for specifying and controlling compliant robot motion. *Proc. 25th Conf. Decision and Control,* 1986, 1871-1876
- **J. A. MAPLES ; J. J. BECKER.** Experiments in force control of robotic manipulators. *Proc. IEEE Int. Conf. Robotics and Automation,* 1986, 695-702
- **K. KOSUGE ; K. FURUTA ; T. YOKOYAMA.** Virtual internal model following control of robot arms. *Proc. 1987 IEEE Int. Conf. Robotics and Automation,* 1987, 1549-1554
- **D. A. LAWRENCE ; R. M. STOUGHTON.** Position-based impedance control - achieving stability in practice. *Proc. AIAA Guidance, Navigation and Control Conference,* 1987, 221-226
- **D. SURDILOVIC ; J. KIRCHHOF.** A new position based force/impedance control for industrial robots. *Proc. IEEE Int. Conf. Robotics and Automation,* 1996, 629-634
- **R. VOLPE ; P. K. KHOSLA.** A theoretical and experimental investigation of explicit force control strategies for manipulators. *IEEE Trans. Automatic Control,* 1993, vol. 38 (11), 1634-1650
- **J. J. GONZALEZ ; G. R. WIDMANN.** A force commanded impedance control scheme for robots with hard nonlinearities. *IEEE Trans. Control Systems Technology,* 1995, vol. 3 (4), 398-408

- **D. A. LAWRENCE.** Impedance control stability properties in common implementation. *Proc. IEEE Int. Conf. Robotics and Automation,* 1988, 1185-1190
- **S. D. EPPINGER ; W. P. SEERING.** Understanding bandwidth limitations in robot force control. *Proc. IEEE Int. Conf. Robotics and Automation,* 1987, vol. 4, 904-909
- **T. VALENCY ; M. ZACKSENHOUSE.** Accuracy/robustness dilemma in impedance control. *Trans. ASME: J. Dynamic Systems, Measurement, and Control,* 2003, vol. 125 (3), 310-319
- **S. H. KANG ; M. JIN ; P. H. CHANG.** A solution to the accuracy/ robustness dilemma in impedance control. *IEEE/ASME Trans. Mechatronics,* 2009, vol. 14 (3), 282-294
- **S. TAFAZOLI ; S. E. SALCUDEAN ; K. HASHTRUDI-ZAAD ; P.D. LAWRENCE.** Impedance control of a teleoperated excavator. *IEEE Trans. Control Systems Technology,* 2002, vol. 10 (3), 355-367
- **G. FERRETTI ; G. MAGNANI ; P. ROCCO.** Impedance control for elastic joints industrial manipulators. *IEEE Trans. Robotics and Automation,* 2004, vol. 20 (3), 488-498
- **J. J. GONZALEZ ; G. R. WIDMANN.** Investigation of nonlinearities in the force control of real robots. *IEEE Trans. Systems, Man, and Cybernetics,* 1992, vol. 22 (5), 1183-1193
- Numerical Methods Nonsmooth Dynamical Systems. **ACARY, V. ; BROGLIATO, B.** Applications in Mechanics and Electronics, Lecture Notes in Applied and Computational Mechanics. Springer, 2008, vol. 35